**Europäisches Patentamt**

**European Patent Office**

**Office européen des brevets**

(19)

(11) Veröffentlichungsnummer : **0 091 169**
**B1**

(12) **EUROPÄISCHE PATENTSCHRIFT**

(45) Veröffentlichungstag der Patentschrift :
**30.09.87**

(51) Int. Cl.⁴ : **H 03 J   5/24**

(21) Anmeldenummer : **83200463.4**

(22) Anmeldetag : **31.03.83**

(54) **Zweikreisiges Resonanz-Bandfilter für Kanalwähler.**

(30) Priorität : **06.04.82 DE 3212731**

(43) Veröffentlichungstag der Anmeldung :
**12.10.83 Patentblatt 83/41**

(45) Bekanntmachung des Hinweises auf die Patenterteilung : **30.09.87 Patentblatt 87/40**

(84) Benannte Vertragsstaaten :
**BE CH DE GB IT LI**

(56) Entgegenhaltungen :
**DE-A- 2 523 536
DE-A- 2 849 178
IEEE TRANSACTIONS ON CONSUMER ELECTRO-
NICS, August 1976, Seiten 203-209, New York, US;
G.W. CARTER: "New VHF and UHF varactor tuners"**

(73) Patentinhaber : **Philips Patentverwaltung GmbH
Wendenstrasse 35 Postfach 10 51 49
D-2000 Hamburg 1 (DE)
DE
N.V. Philips' Gloeilampenfabrieken
Groenewoudseweg 1
NL-5621 BA Eindhoven (NL)
BE CH GB IT LI**

(72) Erfinder : **Kupfer, Karl-Heinz
Krefelder Strasse 145
D-4150 Krefeld 29 (DE)**

(74) Vertreter : **Hartmann, Heinrich, Dipl.-Ing. et al
Philips Patentverwaltung GmbH Wendenstrasse 35
Postfach 10 51 49
D-2000 Hamburg 1 (DE)**

## Beschreibung

Die Erfindung betrifft ein zweikreisiges Resonanz-Bandfilter für Kanalwähler mit elektronischen Schaltern zum Umschalten des Filters von einem ersten Frequenzband in ein zweites Frequenzband.

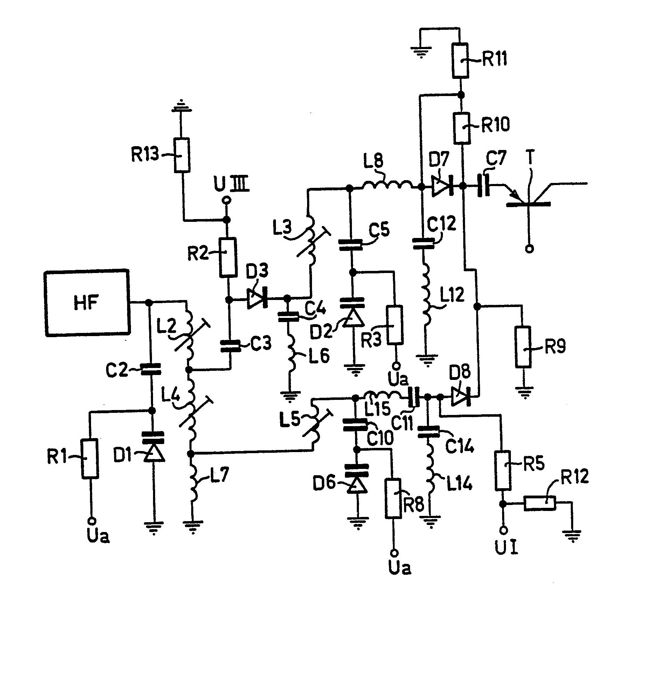

Ein solches Filter ist aus der Zeitschrift « IEEE-Trans. CE-22 » N°. 3, August 1976, Seiten 203 bis 209, insb. Fig. 2 und 3 bekannt. Das bekannte Bandfilter ist in einem Kanalwähler zwischen die Hochfrequenz-Eingangsstufe und eine Mischstufe geschaltet. Sowohl die Hochfrequenz-Eingangsstufe als auch die Mischstufe werden durch Feldeffekttransistoren gebildet, die den Eingang und den Ausgang des Filters praktisch nicht belasten. Die Dämpfung des Filters ist daher durch die endliche Güte der darin verwendeten Spulen und Kondensatoren bzw. Kapazitätsdioden gegeben sowie durch den von Null verschiedenen Durchlaßwiderstand der als elektronischer Schalter dienenden beiden Schaltdioden. Primärkreis und Sekundärkreis werden dabei also annähernd gleichmäßig bedämpft.

Feldeffekttransistoren als Mischstufen sind aber einerseits relativ teuer, engen den Frequenzhub durch Parallelschaltung der Gatekapazität (ca. 3 pF) zur Schwingkreiskapazität (ca. 4 pF) erheblich ein und erfordern eine relativ große Amplitude des Oszillatorsignals für die Mischung. Verwendet man jedoch als Mischstufe einen bipolaren Transistor in Basisschaltung, wird die Sekundärseite des Bandfilters erheblich zusätzlich belastet, und zwar auch dann, wenn zwischen den Ausgang des Filters und den Eingang der Mischstufe zur Entkopplung eine Spule geschaltet wird. Es kommt hinzu, daß für eine optimale Entkopplung bzw. Anpassung die Induktivität dieser Spule im höheren Frequenzband einen anderen Wert haben muß als im niedrigeren Frequenzband. Unterteilt man daher die Spule in zwei Teilspulen und schließt die eine für das höhere Frequenzband durch einen elektronischen Schalter — in der Regel eine Schaltdiode — kurz, dann wirkt im unteren Frequenzband die unvermeidliche Kapazität des elektronischen Schalters parallel zu der Spule, was zu Einbrüchen im Frequenzgang führen kann.

Besonders ausgeprägt sind die geschilderten Nachteile bei sogenannten S-Bandkanalwählern, d. h. Kanalwählern für Sonderkanäle, wie sie z. B. bei Kabelfernsehanlagen benötigt werden. Dabei reicht der VHF-Bereich I von 48,25 bis etwa 108 MHz und der VHF-Bereich III von etwa 109 MHz bis rund 300 MHz.

Bei einem bekannten S-Bandkanalwähler (vgl. Valvo-Handbuch « Fernsehtuner, Verzögerungsleitungen » 1978, Seiten 121 bis 136) ist daher die einen bipolaren in Basisschaltung betriebenen Transistor enthaltende Mischstufe über je eine Schaltdiode mit je einer Hochfrequenz-Eingangsstufe verbunden, wobei zwischen den Ausgang jeder der beiden Hochfrequenz-Eingangsstufen und den Eingang der Mischstufe je ein vollständiges zweikreisiges Bandfilter für das untere bzw. das obere Frequenzband geschaltet ist. Im Gegensatz zu dem eingangs erwähnten bekannten Kanalwähler wird das Bandfilter durch die Schaltdioden praktisch nicht gedämpft. Ein Nachteil des bekannten Kanalwählers besteht jedoch darin, daß der Bauelementeaufwand praktisch verdoppelt wird.

Aufgabe der vorliegenden Erfindung ist es, ein zweikreisiges Bandfilter der eingangs genannten Art für zwei Frequenzbereiche, insbesondere die VHF-Bereiche I und III, mit geringem Aufwand so auszugestalten, daß die Dämpfung des Bandfilters im gesamtem Frequenzbereich vorzugsweise am niederfrequenten Ende des oberen Frequenzbereiches verringert wird.

Diese Aufgabe wird erfindungsgemäß dadurch gelöst, daß mit dem Primärkreis zwei Sekundärkreise gekoppelt sind, daß die beiden Sekundärkreise über je einen elektronischen Schalter mit der Mischstufe gekoppelt sind, und daß der Primärkreis mit dem Sekundärkreis für das höhere Frequenzband über einen weiteren elektronischen Schalter verbunden ist, der so geschaltet ist, daß er in geschlossenem Zustand den Eingang des zweiten Sekundärkreises über für das niedrigere Frequenzband niederohmige Blindwiderstände praktisch kurzschließt und in offenem Zustand den Sekundärkreis für das höhere Frequenzband vom Primärkreis trennt.

Die Erfindung wird nachstehend anhand der Zeichnung näher erläutert, die den für die Erfindung wesentlichen Teil eines S-Bandkanalwählers für die VHF-Bereiche I und III darstellt.

An den hochohmigen Ausgang einer Hochfrequenz-Eingangsstufe HF ist der beiden Frequenzbändern gemeinsame Primärkreis eines Bandfilters angeschlossen. Der Primärkreis besteht aus der Parallelschaltung eines kapazitiven Zweiges und eines induktiven Zweiges. Der kapazitive Zweig umfaßt einen mit dem Ausgang der Hochfrequenz-Eingangsstufe HF verbundenen Kondensator C2 von 4,7 nF, der über eine Kapazitätsdiode D1 vom Typ BB 109 mit Masse verbunden ist. Der induktive Zweig besteht aus der Serienschaltung dreier Spulen L2, L4 und L7, die — in dieser Reihenfolge — zwischen den Ausgang der HF-Verstärkerstufe HF und Masse geschaltet sind. Die Spule L2 von etwa 40 nH ist ebenso abgleichbar wie die Spule L4 von rund 190 nH.

Die Spule L7, deren einer Anschluß mit Masse verbunden ist, bildet die Koppelinduktivität des zweikreisigen Bandfilters für den VHF-Bereich I, dessen Sekundärkreis die Spule L5 mit abgleichbarer Induktivität enthält, die zwischen den Verbindungspunkt der Spulen L4 und L7 und die Serienschaltung eines Kondensators C10 und einer Kapazitätsdiode D6 geschaltet ist, deren zweiter Anschluß an Masse angeschlossen ist.

Die Kapazität der Kapazitätsdiode D6 ist durch eine in Sperrichtung und über den Widerstand R8 von 15 kOhm zugeführte Abstimmspannung Ua veränderbar — ebenso wie die Kapazität der Kapazitätsdiode D1, die über einen Widerstand R1 von 39 kOhm durch die Abstimmspannung Ua verändert wird. Der Sekundärkreis ist über eine Ankoppelspule L15 von 220 nH in Serie mit einem Trennkondensatoren C11 von 10 nF mit einer Schaltdiode D8 verbunden, deren Kathode mit einem Kondensator C7 verbunden ist, dessen anderer Anschluß mit dem Emitter des Mischstufentransistors T verbunden.

Die Vospannung für die Basis und den Emitter dieses Transistors wird von einem nicht näher dargestellten Spannungsteiler geliefert, während sein Kollektor über den nicht näher dargestellten Zwischenfrequenz-Ausgangskreis mit Masse verbunden ist. Der Verbindungspunkt der Kathode der Schaltdiode D8 und des Kondensators C7 ist über einen Widerstand R9 von 1 kOhm mit Masse verbunden. Die Schaltdiode D8 wird durch eine Schaltspannung UI leitend gemacht, die ihrer mit der Spule L15 verbundenen Anode über einen Widerstand R5 zugeführt wird und die an einem Widerstand R 12 von 22 kOhm abfällt. Der Verbindungspunkt der Spule L15 und der Schaltdiode D8 ist außerdem über einen auf die Zwischenfrequenz (36,5) abgestimmten Serien-Resonanzkreis, der aus einer Induktivität L14 von etwa 125 nH und einer Kapazität C14 von 150 pF besteht, mit Masse verbunden.

Der Verbindungspunkt der beiden Spulen L2, L4 des Primärkreises ist über einen Trennkondensator C3 von 10 nF mit der Anode einer Schaltdiode D3 verbunden, deren Kathode über einen Trennkondensator C4 von 10 nF mit einer Spule L6 von 7 nH verbunden ist, die als Koppelspule für den VHF-Bereich III dient. Die Kathode der Diode D3 ist außerdem mit dem Sekundärkreis für den VHF-Bereich III verbunden, der eine abgleichbare Spule L3 von 60 Nh umfaßt, die zwischen die Diode D3 und die Serienschaltung eines Kondensators C5 von 1,8 nF und einer Kapazitätsdiode D2 vom Typ BB 109 geschaltet ist, deren zweiter Anschluß an Masse angeschlossen ist und deren Kapazität ebenfalls durch die Abstimmspannung Ua veränderbar ist, die über den Widerstand R3 zugeführt wird. Der Sekundärkreis ist über eine Spule L8 von 100 nH mit der Anode einer Diode D7 verbunden, deren Kathode mit dem Kondensator C7 verbunden ist. Der Verbindungspunkt der Spule L8 und der Diode D7 ist über einen auf die Zwischenfrequenz abgestimmten Serien-Resonanzkreis, der aus der Spule L12 mit einer Induktivität von rund 55 nH und einer Kapazität von 330 pF besteht, mit Masse verbunden. Der Diode D7 ist ein Widerstand R10 von 22 kOhm parallelgeschaltet, und ein gleich großer Widerstand R 11 verbindet die Anode der Diode D7 mit Masse.

Die Spulen L2 und L3 sind so abgeglichen, daß der Primärkreis und der Sekundärkreis bei denselben Frequenzen im VHF-Bereich III in Resonanz sind. Auch die Spulen L4 und L5 sind so abgeglichen, daß der Primärkreis und der andere Sekundärkreis bei jeweils der gleichen Frequenz im VHF-Bereich I in Resonanz sind.

Die Schaltdioden D3 und D7 können durch eine Schaltspannung UIII leitend gemacht werden, die der Anode der Diode D3 über einen Widerstand R2 von 3,9 kOhm zugeführt wird und die an einem Widerstand R13 von 22 kOhm abfällt ; der Schaltstrom fließt dann über die Diode D3, die Spulen L3 und L8, die Schaltdiode D7 und den Widerstand R9 nach Masse. In diesem Betriebszustand, in dem der VHF-Bereich III empfangen wird, ist der aus den Spulen L4 und L7 bestehende Teil des Primärkreises über den Kondensator C3, die Diode D3, den Kondensator C4 und die Koppelspule L6 für die VHF-Frequenzen im Bereich I praktisch kurzgeschlossen. Die Diode D8 ist durch die am Widerstand R9 durch den Schaltstrom erzeugte Spannung gesperrt. Die Spule L8 dient der Anpassung des Einganges der Mischstufe an den Sekundärkreis des Filters. Der Serien-Resonanzkreis L12, C12 unterdrückt die Zwischenfrequenz am Emitter des Transistors.

Zum Empfang von Signalen aus dem VHF-Bereich I ist die Schaltspannung UIII ab- und die Schaltspannung UI eingeschaltet, wodurch die Diode D8 leitend und die Dioden D7 und D3 über dem Spannungsabfall R9 gesperrt werden. Die Spule L15 und der Serien-Resonanzkreis L14, C14 haben die gleiche Funktion wie die Spule L8 bzw. der Serien-Resonanzkreis L12, C12, jedoch haben sie eine dem VHF-Bereich I angepaßte Induktivität bzw. einen daran angepaßten Kennwiderstand.

Wird das Bandfilter im VHF-Bereich III betrieben (D3 und D7 leitend, D8 gesperrt), dann wird der Primärkreis durch die Diode D3 und der Sekundärkreis nur durch den Eingang der Mischstufe T bedämpft. Die Bedämpfung ist also geringer als wenn das aus « IEEE Transactions on consuma electronics » August 1976 bekannte Bandfilter zwischen der HF-Eingangsstufe und der Mischstufe T eingeschaltet wäre. Mit der Dämpfungsverringerung geht eine Selektivitätsverbesserung einher. Einbrüche im Frequenzgang treten nicht auf, weil jeder Sekundärkreis und die zugehörigen Koppelspulen, sowie der ZF-Serien-Resonanzkreis optimal für den jeweiligen Frequenzbereich ausgelegt werden kann.

Der Mehraufwand ist gering, wenn man bedenkt, daß auch bei Benutzung des bekannten Bandfilters zwei Spulen zur Ankopplung und zwei ZF-Serien-Resonanzkreise vorhanden sein müßten, von denen jeweils eine bzw. einer durch eine zusätzliche Schaltdiode kurzgeschlossen werden müßte. Es ist dann nämlich nur noch eine Kapazitätsdiode und der zugehörige Trennkondensator zusätzlich erforderlich.

**Patentansprüche**

1. Zweikreisiges Resonanz-Bandfilter für Kanalwähler mit elektronischen Schaltern zum Umschalten des Filters von einem ersten Frequenzband in ein zweites Frequenzband, dadurch gekennzeichnet, daß mit dem Primärkreis (D1, L2, L4) zwei Sekundärkreise (L3, D2 ; L5, D6) gekoppelt sind, daß die beiden Sekundärkreise über je einen elektronischen Schalter (D7, D8) mit der Mischstufe (T) gekoppelt sind, und daß der Primärkreis mit dem Sekundärkreis (L3, D2) für das höhere Frequenzband über einen weiteren elektronischen Schalter (D3) verbunden ist, der so geschaltet ist, daß er in geschlossenem Zustand den Eingang des zweiten Sekundärkreises über für das niedrigere Frequenzband niederohmige Blindstände praktisch kurzschließt und im offenem Zustand den Sekundärkreis für das höhere Frequenzband vom Primärkreis trennt.

2. Bandfilter nach Anspruch 1, dadurch gekennzeichnet, daß das Bandfilter für beide Frequenzbänder eine querinduktive Kopplung aufweist, daß die Spule im Primärkreis zwei Anzapfungen aufweist, daß die Anzapfung, an der die höhere Signalamplitude anliegt, über den weiteren elektronischen Schalter mit der Koppelinduktivität (L6) für das höhere Frequenzband verbunden ist, und daß der zwischen der anderen Anzapfung und Masse liegende Teil (L7) der Spule im Primärkreis die Koppelinduktivität für das niedrigere Frequenzband bildet.

3. Bandfilter nach einem der vorhergehenden Ansprüche, wobei als Mischstufe ein in Basisschaltung betriebener bipolarer Transistor dient, dadurch gekennzeichnet, daß der Eingang der Mischstufe (T) mit zwei elektronischen Schaltern (D7, D8) verbunden ist, und daß die elektronischen Schalter über je eine in Serie geschaltete Spule (L8, L15) mit je einem der Sekundärkreise (L3, D2 ; L5, D6) verbunden sind.

4. Schaltungsanordnung nach Anspruch 3, dadurch gekennzeichnet, daß der Verbindungspunkt wenigstens einer der beiden Serienschaltungen aus elektronischem Schalter (D7, D8) und der zuletzt genannten Spule (L8, L15) über einen auf die Zwischenfrequenz abgestimmten Serien-Resonanzkreis (L12, C12 ; L14, C14) mit Masse verbunden ist.

**Claims**

1. A two-circuit resonant bandpass filter for channel selectors comprising electronic switches for switching the filter from a first frequency band to a second frequency band, characterized in that two secondary circuits (L3, D2 ; L5, D6) are coupled to a primary circuit (D1, L2, L4), in that the two secondary circuits are each coupled to a mixing stage (T) via an electronic switch (D7, D8) and in that the primary circuit is connected to the secondary circuit (L3, D2) for the higher frequency band via another electronic switch (D3) which is arranged such that in the closed state it substantially shortcircuits the input of the second secondary circuit via reactances which are lowohmic for the lower frequency band and, in the open state, it separates the secondary circuit from the primary circuit for the higher frequency band.

2. A bandpass filter as claimed in Claim 1, characterized in that for both frequency bands the bandpass filter evidences a shunt inductive coupling, in that a coil in the primary circuit has two branches, a higher signal amplitude being present at one branch, which branch is connected via the other electronic switch to a coupling inductance (L6) for the higher frequency band and in that a coil section (17) arranged between the other branch and ground provides in the primary circuit a coupling inductance for the lower frequency band.

3. A bandpass filter as claimed in any of the preceding Claims, a bipolar transistor which is operated in the grounded-base mode serving as the mixer stage, characterized in that the input of the mixer stage (T) is connected to the beforementioned two electronic switches (D7, D8) and in that the electronic switches are each connected to one of the secondary circuits (L3, D2 ; L5, D6) via a series-arranged coil (L8, L15).

4. A circuit arrangement as claimed in Claim 3, characterized in that the junction of at least one of the two series arrangements of the electronic switch (D7, D8) and the last-mentioned coil (L8, L15) is connected to ground via a series resonant circuit (L12, C12 ; L14, C14) tuned to the intermediate frequency).

**Revendications**

1. Filtre passe-bande à deux circuits résonnants pour des sélecteurs de canaux comportant des commutateurs électroniques pour commuter le filtre d'une première bande de fréquence à une seconde bande de fréquence, caractérisé en ce que deux circuits secondaires (L3, D2 ; L5, D6) sont couplés au circuit primaire (D1, L2, L4), que les deux circuits secondaires sont couplés à l'étage mélangeur (T) chacun par l'intermédiaire d'un commutateur électronique (D7, D8) et que le circuit primaire est connecté au circuit secondaire (L3, D2) pour la bande de fréquence supérieure par l'intermédiaire d'un autre commutateur électronique (D3) qui est monté d'une manière telle que dans l'état de fermeture, il court-circuite pratiquement l'entrée du second circuit secondaire, par l'intermédiaire de réactances à faible valeur ohmique pour la bande de fréquence inférieure, et que dans l'état d'ouverture, il sépare le circuit secondaire pour la bande de fréquence supérieure du circuit primaire.

2. Filtre passe-bande suivant la revendication 1, caractérisé en ce qu'il présente un couplage inductif transversal pour les deux bandes de fréquence, que la bobine dans le circuit primaire présente deux prises, que la prise sur laquelle l'amplitude de signal supérieure est appliquée, est connectée par l'intermédiaire de l'autre commutateur électronique à l'inductance de couplage (L6) pour la bande de fréquence supérieure et que la partie (L7) de la bobine qui se trouve entre l'autre prise et la masse forme, dans le circuit primaire, l'inductance de couplage pour la bande de fréquence inférieure.

3. Filtre passe-bande suivant l'une quelconque des revendications précédentes, dans lequel un transistor bipolaire fonctionnant en circuit de base sert d'étage mélangeur, caractérisé en ce que l'entrée de l'étage mélangeur (T) est connectée à deux commutateurs électroniques (D7, D8) et que les commutateurs électroniques sont connectés chacun par l'intermédiaire d'une bobine connectée en série (L8, L15) chaque fois à un des circuits secondaires (L3, D2 ; L5, D6).

4. Montage de circuit suivant la revendication 3, caractérisé en ce que le point de jonction d'au moins un des deux montages en série formés du commutateur électronique (D7, D8) et de la bobine (L8, L15) mentionnée en dernier lieu est connecté à la masse par l'intermédiaire du circuit résonnant série (L12, C12 ; L14, C14) accordé sur la fréquence intermédiaire.